# EUROPEAN PATENT APPLICATION

(11) **EP 2 372 736 A1**
(43) Date of publication of application: **05.10.2011**
(21) Application number: 11159097.2
(22) Date of filing: 22.03.2011
(51) Int. Cl.: H01H 3/00, H01H 11/00, H01H 47/00, G01R 31/327

(54) **Relay-end-of-service-life forecasting device and method**

(30) Priority: 30.03.2010 JP 2010077247
(71) Applicant: Yamatake Corporation, Tokyo 100-6419 (JP)
(72) Inventor: Akita, Daisuke, Tokyo 100-6419 (JP); Kumazawa, Yuuichi, Tokyo 100-6419 (JP)
(74) Representative: Kling, Simone

(57) **Abstract**

Forecasting the end of the service life of a relay more accurately due to the effects of the load conditions and the environmental conditions can occur through diagnosing the end of service life of the relay based on the time, until the point in time that the actual opening or closing of the relay is detected, from the point in time of the application of the power to the relay or the point in time of the end of application of power to the relay coil by the controlling portion. Forecasting the end of the service life of the relay based on time, increases accuracy because time is a value that is not affected by the external environment. Additionally, because the end of the service life is forecasted based on the actual opening/closing of the relay, not only is it possible to detect immediately a fault in the relay, but it is also possible to eliminate the effects due to individual differences.

## Description

### Cross Reference to Related Applications

The present application claims priority to Japanese Patent Application No. 2010-077247, filed March 30, 2010, which is incorporated herein by reference.

### Field of Technology

The present invention relates to an end-of-service-life forecasting device for forecasting the end of the service life of an electromagnetic relay. Further the present invention relates to a method for forecasting the end-of-service-life of a relay.

### Background of the Invention

Electromagnetic relays comprising a relay coil and a relay contact that is opened and closed through the application of an electric current to the relay coil are broadly and generally known. The relay contacts in such relays are switched mechanically between ON and OFF by magnetic forces generated by the coil. In mechanical switches, including this type of relay, when the contact is turned ON or OFF, an electric discharge is produced between the electrodes of the contacts, where the heat due to the electric discharge melts the surfaces of the electrodes, forming recessed and raised patterns on the surfaces. In the electrodes wherein uneven surfaces are formed, the electric discharges tend to initiate at the recessed/raised surfaces, and thus the recessed and raised portions propagate as the relay contacts are switched repetitively between ON and OFF multiple times, ultimately causing the electrodes, wherein the surfaces have been melted by the heat, to weld together, causing the contacts to become stuck perpetually in the ON state. End-of-service-life forecasts are performed in order to evaluate whether a relay that is currently in use can be evaluated as being safe from producing a welded contact, or whether it is better to switch the relay due to the likelihood of the occurrence of welding. For example, electromagnetic relay contact end-of-service-life forecasts are performed by comparing the number of opening/closing cycles for the contacts that is the durability reported by the manufacturer to the actual number of opening/closing cycles, or through calculations based on the electric current flowing in the relay (See, for example, Japanese Unexamined Patent Application Publication H05-266290 ("JP '290")).

However, it is difficult to forecast the end of the service life of the electromagnetic relay accurately using the methods set forth above. For example, in the method wherein the number of opening/closing cycles of the contacts that is the durability reported by the manufacturer is compared to the actual number of opening/closing cycles for the contacts, there are cases wherein the loading conditions (the resistance, voltage, electric current, and the like, in the circuit that includes the electromagnetic relay) may be different from measurement to measurement, causing large discrepancies in the respective number of opening/closing cycles prior to failure, and thus the accuracy of the forecast will be less the greater the difference between the actual limit cycle count in the actual equipment and the value reported by the manufacturer. Moreover, in the method of calculating the service life by substituting load conditions, such as the electric current, into a specific end-of-service-life forecasting equation, as disclosed in JP '290, there will be cases wherein the load conditions anticipated in advance to not match the loads produced in actual use, due to, for example, the resistance values within the electromagnetic relays varying due to environmental factors such as the mechanism, the ambient gas, noise, and the like, and the accuracy of the forecast will suffer in such cases.

Given this, the object of the invention in the present application is to provide a relay end-of-service-life forecasting device able to forecast the end of the service life of an electromagnetic relay accurately.

### Summary of the Invention

In order to solve the problem set forth above, the relay end-of-service-life forecasting device including a relay having a relay coil and a relay contact that is opened and closed by the application of an electric current to the relay coil; a controlling portion for controlling the opening/closing of the relay through controlling the application of the electric current to the relay coil; a detecting portion for detecting the actual opening/closing of the relay; a measuring portion for measuring the time from a point in time wherein the application of the electric current to the relay coil is started by the controlling portion, or from the point in time that the application of the electric current to the relay coil is stopped by the controlling portion, until the point in time that the opening/closing of the relay is detected by the detecting portion; and a diagnosing portion for diagnosing the end of the service life of the relay based on the measurement results by the measuring portion.

In the relay end-of-service-life forecasting device as set forth above, the diagnosing portion may diagnose the end of the relay service life of the relay based on a comparison of the amount of change in the opening/closing count and the amount of change in the measurement result, from among the measurement results by the measuring portion.

Additionally, in the relay end-of-service-life forecasting device set forth above, the diagnosing portion may diagnose the end of the relay service life through comparing the value of the measurement result to a predetermined threshold value, from among the measurement results by the measuring portion.

Additionally, a method for forecasting the end-of-service-life of a relay according to claim 4 is provided. Further advantages, features, aspects and details are evident from the dependent claims, the description and the drawings.

Given the present invention, the diagnosing of the end of the service life of the relay based on the time from a point in time wherein the application of the electric current to the relay coil is started by the controlling portion, or from the point in time that the application of the electric current to the relay coil is stopped by the controlling portion, until the point in time that the opening/closing of the relay is detected by the detecting portion makes it possible to forecast the end of the service life of the electromagnetic relay accurately, without a significant drop in the forecasting accuracy due to the effects of the load conditions or the environmental conditions.

Forecasting the end of the service life of a relay more accurately due to the effects of the load conditions and the environmental conditions can occur through diagnosing the end of service life of the relay based on the time, until the point in time that the actual opening or closing of the relay is detected, from the point in time of the application of the power to the relay or the point in time of the end of application of power to the relay coil by the controlling portion. Forecasting the end of the service life of the relay based on time, increases accuracy because time is a value that is not affected by the external environment. Additionally, because the end of the service life is forecasted based on the actual opening/closing of the relay, not only is it possible to detect immediately a fault in the relay, but it is also possible to eliminate the effects due to individual differences.

### Brief Description of the Drawings

FIG. 1 is a diagram illustrating schematically the structure of end-of-service-life forecasting device according to the present invention.
FIG. 2 is a diagram illustrating an example of an electric circuit used in examining the electromagnetic relay.
FIG. 3 is an experimental result in the electric circuit in FIG. 2.
FIG. 4 is an experimental result in the electric circuit in FIG. 2.
FIG. 5 is a diagram illustrating the relationship between the operating time and return time and the opening/closing count.

### Detailed Description of the Invention

An example of the present invention will be described in detail below in reference to the drawings.

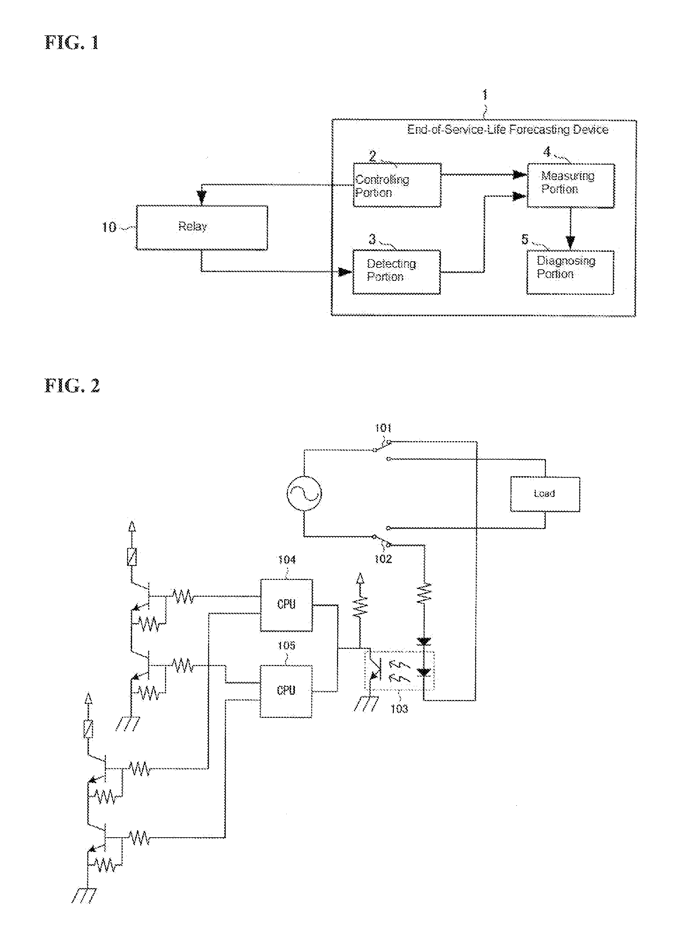

As illustrated in FIG. 1, the end-of-service-life forecasting device 1 in an example includes a controlling portion 2 for controlling the opening/closing of a relay 10; a detecting portion 3 for detecting the opening/closing of the contacts of the relay 10; a measuring portion 4 for measuring the time required to open/close the relay 10; and a diagnosing portion 5 for diagnosing the end of the service life of the relay 10 based on the measurement result by the measuring portion 4.

The controlling portion 2 is structured from an electric circuit for controlling the opening/closing of the relay 10. This controlling portion 2 provides notification to the measuring portion 4 when a control signal that is an instruction for opening/closing is outputted to the relay 10.

The detecting portion 3 is structured from a detecting device that detects the actual opening/closing of the relay 10. This detecting portion 3 provides notification to the measuring portion 4 when opening/closing of the relay 10 is detected.

The measuring portion 4 is structured from a measuring device that measures the time from the point in time wherein the control signal is outputted from the controlling portion 2 to the relay 10, or the point in time wherein the output (an electric current) of the control signal from the controlling portion 2 to the relay 10 is stopped, until the point in time wherein the relay 10 actually opens or closes, based on the control signal, according to the detecting portion 3. Specifically, the measuring portion 4 measures the response time (hereinafter termed the "operating time") from the point in time wherein the control signal instructing the contacts to close is outputted from the controlling portion 2 to the relay 10, that is, from the point in time wherein the application of the electric current to the relay 10 is started until the point in time at which the actual closing of the relay 10 is detected by the detecting portion 3, and measures the response time (hereinafter termed the "return time") from the point in time wherein the output of the control signal instructing the contacts to open is outputted from the controlling portion 2 to the relay 10, that is, from the point in time wherein the application of the electric current to the relay 10 is stopped, until the point in time wherein the actual opening of the relay 10 is detected by the detecting portion 3. These measurement results are outputted to the diagnosing portion 5.

The diagnosing portion 5 diagnoses the end of the service life of the relay 10 based on the operating time and the return time measured by the measuring portion 4. A correlation is observed between the operating time and return time and the opening/closing cycle count for the electromagnetic relay. This correlation will be explained in reference to FIG. 2 through FIG. 5.

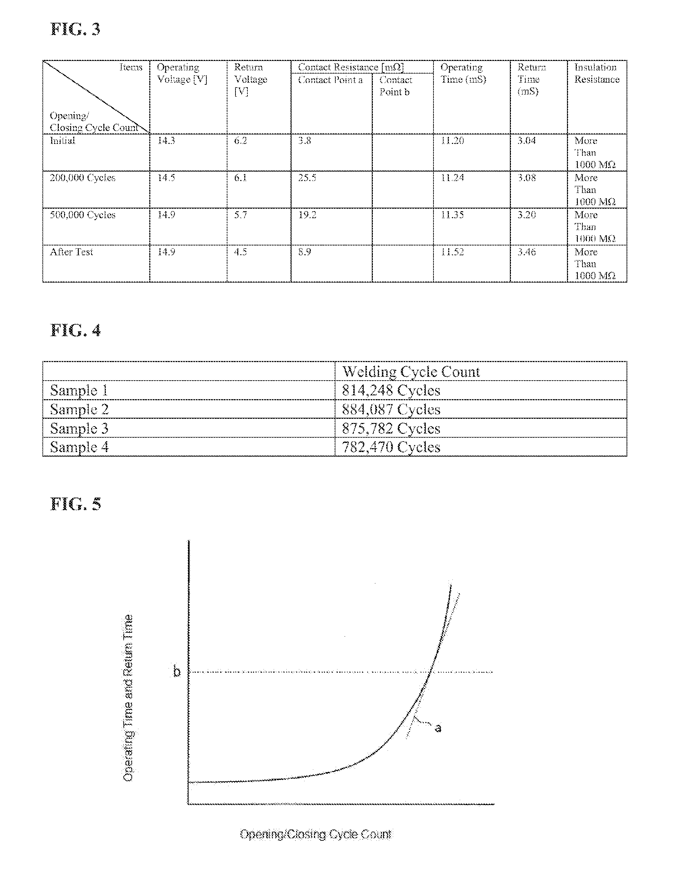

Electromagnetic relay durability testing was performed on the electric circuit as illustrated in FIG. 2. Here an Omron LY2 (24 V DC) electromagnetic relay was used as the electromagnetic relay for structuring the switches 101 and 102, where a photocoupler circuit 103 is connected to the contacts of the relay, and opening/closing instructions were outputted to the aforementioned relays, and the operating time and return time thereof were measured by a CPU 104 and a CPU 105. The results of performing these types of measurements on samples 1 through 4 are presented in FIG. 3 and FIG. 4.

As illustrated in FIG. 3, the operating time and the return time increased in accordance with the number of opening/closing cycles, and increased further immediately prior to the occurrence of the point in time wherein the electromagnetic relay welded. That is, as illustrated in FIG. 5, the operating time and return time, and the number of opening/closing cycles, formed a second-order curve. Note that in FIG. 3, "after testing" is at the number of cycles at which that there was welding of contacts, where the values in this column are values that were measured in the same manner after separating the contacts after they had been welded.

Here the diagnosing portion 5 diagnoses the end of the service life of the relay 10 based on a comparison of the amount of change in the return time and the operating time and the amount of change in the number of opening/closing cycles. For example, as indicated by the code "a" in FIG. 5, when the value for the slope of the tangent of the curve of the return time or the operating time exceeds a specific value, then the diagnosis is that the end of the service life of the relay 10 is approaching. This specific value may be set in advance based on measurement results for samples, as described above. Note that the diagnosing results may be displayed on a display, or the like, or may be outputted from a speaker.

In this way, the present example makes it possible to forecast the end of the service life of the relay 10 more accurately, by performing the diagnosis of the end of the service life of the relay 10 based on the time from the point in time of the beginning of the application of the electric current to the relay 10 or the point in time of the end of the application of the electric current to the relay coil by the controlling portion 2 and the point in time at which the actual opening/closing of the relay 10 is detected, without any significant drop in the forecasting accuracy due to the effects of the load conditions and the environmental conditions. That is, it is possible to forecast the end of the service life of the relay 10 more accurately by forecasting the end of the service life of the relay 10 based on time, which is a value that is not affected by the external environment. Additionally, because the end of the service life is forecasted based on the actual opening/closing of the relay 10, not only is it possible to detect immediately a fault in the relay 10, but it is also possible to eliminate the effects due to individual differences, making it possible to forecast the end of the service life of the relay 10 more accurately.

Note that in the present example the end of the service life of an electromagnetic relay was diagnosed based on the value of the slope of the tangent of the curve for the return time or the operating time in the diagnosing portion 5. Instead a specific threshold value may be provided for the return time or the operating time, as indicated by code "b" in FIG. 5, and the diagnosing of the approaching end of service life may be made when that threshold value is surpassed. In this case, the number of opening/closing cycles need not be counted.

Furthermore, the measuring portion 4 need not necessarily perform the measurement of the return time and the operating time with each cycle. For example, the measurement may be performed at each specific number of cycles, such as with each thousandth opening/closing cycle of the relay 10.

The present invention can be applied to various types of devices equipped with electromagnetic relays.

## Claims

1. A relay end-of-service-life forecasting device (1) comprising a relay (10) comprising:
a relay coil and a relay contact opened and closed by the application of an electric current to the relay coil;
a controlling portion (2) controlling the opening/closing of the relay through controlling the application of the electric current to the relay coil;
a detecting portion (3) detecting the actual opening/closing of the relay;
a measuring portion (4) measuring the time from a point in time wherein the application of the electric current to the relay coil is started by the controlling portion, or from the point in time that the application of the electric current to the relay coil is stopped by the controlling portion, until the point in time that the opening/closing of the relay is detected by the detecting portion; and
a diagnosing portion (5) diagnosing the end of the service life of the relay based on the measurement results by the measuring portion.

2. A relay end-of-service-life forecasting device as set forth in Claim 1, wherein:
the diagnosing portion diagnoses the end of the service life of the relay based on an amount of change of an opening/closing cycle count and an amount of change of a measurement result, of the measurement results of the measuring portion.

3. A relay end-of-service-life forecasting device as set forth in one of the Claims 1 or 2, wherein:
the diagnosing portion diagnoses the end of the service life of the relay through comparing a value of the measurement result to a predetermined threshold value, of the measurement results of the measuring portion.

4. A method for forecasting an end-of-service-life forecasting of a relay (10) comprising a relay coil and a relay contact opened and closed by the application of an electric current to the relay coil, the method comprising:
controlling the opening/closing of the relay through controlling the application of the electric current to the relay coil;
detecting the actual opening/closing of the relay;
measuring the time from a point in time wherein the application of the electric current to the relay coil is started, or from the point in time that the application of the electric current to the relay coil is stopped, until the point in time that the opening/closing of the relay is detected; and
diagnosing the end of the service life of the relay based on the measurement results.

5. The method according to claim 4, wherein
the end of the service life of the relay is diagnosed based on an amount of change of an opening/closing cycle count and an amount of change of a measurement result, of the measurement results.

6. The method according to one of the claims 4 or 5, wherein
the end of the service life of the relay is diagnosed through comparing a value of the measurement result to a predetermined threshold value, of the measurement results.
